# EUROPEAN PATENT SPECIFICATION

(11) **EP 3 159 223 B1**
(45) Date of publication and mention of the grant of the patent: **28.02.2018**
(21) Application number: 16194529.0
(22) Date of filing: 19.10.2016
(51) Int. Cl.: B60R 25/04

(54) **VEHICLE THROTTLE LOCKING CIRCUIT AND METHOD**
SCHALTUNG UND VERFAHREN ZUM BLOCKIEREN EINER FAHRZEUGDROSSELKLAPPE
CIRCUIT ET PROCÉDÉ DE BLOCAGE D'ACCÉLÉRATEUR DE VÉHICULE

(30) Priority: 23.10.2015 TW 104134768
(43) Date of publication of application: 26.04.2017
(73) Proprietor: Tsai, William Wei-Lun, Temple City, CA 91780 (US)
(72) Inventor: Tsai, William Wei-Lun, Temple City, CA 91780 (US)
(74) Representative: Horak, Michael

(56) References cited:
- EP-A2- 1 577 179
- US-A1- 2008 255 742
- US-A1- 2013 085 626

## Description

### BACKGROUND OF THE INVENTION

### (a) Technical Field of the Invention

The present invention is generally related to anti-theft devices for vehicles, and more particular to a throttle locking circuit and a related method providing both anti-theft and road safety functions.

### (b) Description of the Prior Art

Motor vehicles satisfy people's traveling requirement and provide people great convenience. However, vehicle theft is always a concern to vehicle owners.

To address this concern, vehicle anti-theft devices equipped on the vehicles are widely popular. In early days, these devices aim at providing alarms to alert vehicle owners so as to deter the burglars. However the effectiveness of these devices is only limited.

Therefore, there are teachings that cut off a stolen vehicle's power to prevent the stolen vehicle from getting away. These are effective means. However, there are safety concerns as a vehicle suddenly losing its power may cause harm to people around.

To overcome this issue, R.O.C. Taiwan Patent No. M466837 teaches an anti-theft device that disables a vehicle's throttle. But the control unit of the teaching encounters difficulty in implementation and further improvement is required.

### SUMMARY OF THE INVENTION

Therefore, an objective of the present invention is to provide a vehicle throttle locking circuit and method so that both anti-theft and driving safety are effectively achieved.

To achieve this and other objectives, the throttle locking circuit is applied to a vehicle equipped with an accelerator pedal sensor and an Electronic Control Unit (ECU). The pedal sensor outputs detection voltages corresponding to a depth of the pedal being stepped on to the ECU.

The throttle locking circuit includes a control unit, a digital-analog (D/A) conversion unit, and a variable voltage clamping unit. The control unit is coupled to the pedal sensor for receiving a clamping actuation signal and, when the clamping actuation signal is ON, outputting digital clamping voltages according to the detection voltages. The D/A conversion unit is coupled to the control unit for converting the digital clamping voltages into analog clamping voltages. The variable voltage clamping unit is coupled to the D/A conversion unit for clamping the detection voltages according to the analog clamping voltages.

In one embodiment, the detection voltages include a high voltage and a low voltage. The digital clamping voltages include a high digital value and a low digital value. The control unit outputs the digital clamping voltages of the high digital value and the low digital value in accordance with the high and low voltages of the detection voltages.

In one embodiment, the D/A conversion unit includes two D/A converters converting the digital clamping voltages of the high digital value and the low digital value into analog clamping voltages including a high analog clamping voltage and a low analog clamping voltage, respectively.

In one embodiment, the variable voltage clamping unit includes two variable voltage clamping circuits clamping the high and low voltages of the detection voltages according to the high and low analog clamping voltages, respectively.

In one embodiment, each variable voltage clamping circuit includes an operational amplifier, a first resistor, a transistor, and a second resistor. The operational amplifier has a positive input terminal, a negative input terminal, and an output terminal. The negative input terminal directly or indirectly receives the high or low analog clamping voltage. The first resistor has an end coupled to the output terminal. The transistor has its base coupled to another end of the first resistor and its emitter connected to ground. The second resistor has its two ends coupled to the collector of the transistor and the positive input terminal, respectively.

In one embodiment, the high and low analog clamping voltages are differential voltages, respectively. Each variable voltage clamping circuit further includes a differential amplifier between one of the D/A converter and the negative input terminal of the operational amplifier for amplifying one of the differential voltages.

In one embodiment, each differential amplifier includes a second operational amplifier, a third resistor, a second transistor, a fourth resistor, and a fifth resistor. The second operational amplifier has a positive input terminal, a negative input terminal, and an output terminal where the positive and negative input terminals receive the differential voltages, respectively. The third resistor has an end coupled to the output terminal of the second operational amplifier. The second transistor has its base coupled to another end of the third resistor and its emitter connected to ground. The fourth resistor has its two ends coupled to the collector of the second transistor and the positive input terminal of the second operational amplifier, respectively. The fifth resistor has its two ends coupled to the collector of the second transistor and a power source, respectively.

The throttle locking method is for a vehicle equipped with an accelerator pedal sensor and an ECU where the pedal sensor outputs detection voltages corresponding to a depth of the pedal being stepped on to the ECU. The method includes the following steps.

Firstly, digital clamping voltages are provided according to the detection voltages when a clamping actuation signal is ON. Secondly, the digital clamping voltages are converted to analog clamping voltages. And the detection voltages are clamped according to the analog clamping voltages.

The detection voltages include a high voltage and a low voltage. The method further includes the step of determining and recording a type of the pedal sensor according to the high and low voltages of the detection voltages.

The method further includes the step of adjusting and providing the digital clamping voltages according to relatively low values of the high and low voltages of the detection voltages and the type of the pedal sensor when the detection voltages suggest that the pedal is released to reduce speed so as to effectively lock the acceleration function of the pedal.

Reducing to the digital clamping voltage is stopped when the detection voltages are already clamped at an idle condition so as to effectively lock the pedal at the idle condition.

As described, the throttle locking circuit and method, when the clamping actuation signal is ON, gradually reduce the clamping voltages until the detection voltages are at an idle voltage. Therefore traffic accident and hazard to the safety of the driver or passers due to the vehicle's sudden loss of power are avoided. The present invention therefore not only provides anti-theft function, but also ensures driving safety.

The foregoing objectives and summary provide only a brief introduction to the present invention. To fully appreciate these and other objects of the present invention as well as the invention itself, all of which will become apparent to those skilled in the art, the following detailed description of the invention and the claims should be read in conjunction with the accompanying drawings. Throughout the specification and drawings identical reference numerals refer to identical or similar parts.

Many other advantages and features of the present invention will become manifest to those versed in the art upon making reference to the detailed description and the accompanying sheets of drawings in which a preferred structural embodiment incorporating the principles of the present invention is shown by way of illustrative example.

### BRIEF DESCRIPTION OF THE DRAWINGS

FIG. 1 is a functional block diagram showing a vehicle throttle locking circuit according to an embodiment of the present invention.
FIG. 2 is a schematic diagram showing a variable voltage clamping circuit of FIG. 1.
FIG. 3 is a flow diagram showing a vehicle throttle locking method according to an embodiment of the present invention.

### DETAILED DESCRIPTION OF THE PREFERRED EMBODIMENTS

The following descriptions are exemplary embodiments only, and are not intended to limit the scope, applicability or configuration of the invention in any way. Rather, the following description provides a convenient illustration for implementing exemplary embodiments of the invention. Various changes to the described embodiments may be made in the function and arrangement of the elements described without departing from the scope of the invention as set forth in the appended claims.

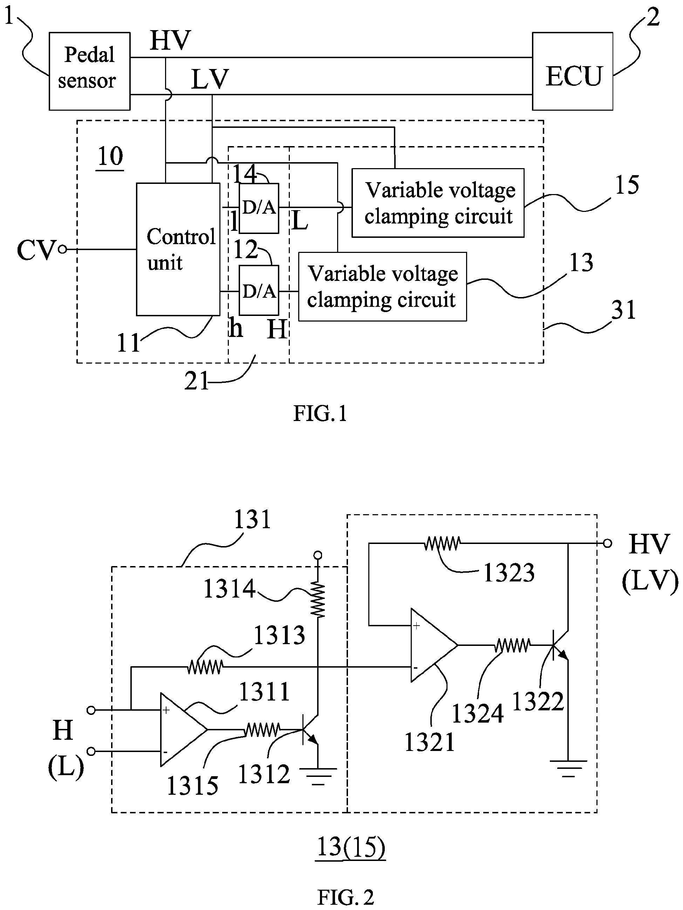

FIG. 1 is a functional block diagram showing a vehicle throttle locking circuit according to an embodiment of the present invention. As illustrated, the throttle locking circuit 10 is applied to a vehicle equipped with an accelerator pedal sensor 1 and an Electronic Control Unit (ECU) 2. The pedal sensor 1 outputs detection voltages including a high voltage HV and a low voltage LV corresponding to a depth of the pedal being stepped on to the ECU 2 so that the ECU 2 is able to control the acceleration and speed of the vehicle.

In FIG. 1, the throttle locking circuit 10 includes a control unit 11, a digital-analog (D/A) conversion unit 21 including D/A converters 12 and 14, and a variable voltage clamping unit 31 including variable voltage clamping circuits 13 and 15.

The control unit 11 is coupled to the pedal sensor 1 and receives a clamping actuation signal CV initiated by a user or by an anti-theft device. When triggered by the clamping actuation signal CV, the control unit 11 outputs digital clamping voltages including a high digital value (h) and a low digital value (1) in accordance with the detection voltages HV and LV.

The digital clamping voltages of high digital value (h) and low digital value (1) output from the control unit 11 are converted by the D/A converters 12 and 14 of the D/A conversion unit 21 into analog clamping voltages including a high analog clamping voltage H and a low analog lamping voltage L, respectively. The variable voltage clamping circuits 13 and 15 of the variable voltage clamping unit 31 then clamp the high and low detection voltages HV and LV according to high and low analog clamping voltages H and L, respectively.

FIG. 2 is a schematic diagram showing the variable voltage clamping circuit 13 or 15 of FIG. 1. As illustrated, the high and low analog clamping voltages H and L output from the D/A converters 12 and 14 are differential voltages. They are first amplified by a differential amplifier 131 of the variable voltage clamp circuit 13 or 15 positioned between the D/A converters 12 or 14 and an operational amplifier 1321. The amplified result is then fed into a negative input terminal of the operational amplifier 1321 so as to conduct clamping to the detection voltages including the high and low voltages HV and LV.

In FIG. 2, the differential amplifier 131 includes an operational amplifier 1311, resistors 1313, 1314, and 1315, and a transistor 1312. The operational amplifier 1311 has a positive input terminal, a negative input terminal, and an output terminal. The positive and negative input terminals receive differential voltages of the high and low analog clamping voltages H and L, respectively. The resistor 1315 has an end coupled to the output terminal of the operational amplifier 1311. The transistor 1312 has its base coupled to another end of the resistor 1315, its emitter connected to ground, and its collector coupled to an end of the resistor 1313. Another end of the resistor 1313 is coupled to the positive input terminal of the operational amplifier 1311. The resistor 1314 has its two ends coupled to the collector of the transistor 1312 and a power source, respectively.

The high and low analog clamping voltages H and L amplified by the differential amplifier 131 are fed into the negative input terminals of the operational amplifiers 1321 of the variable voltage clamping circuits 13 and 15. Or, if the high and low analog clamping voltages H and L output from the D/A converters 12 and 14 are not differential voltages, they may be fed directly into the negative input terminals of the operational amplifiers 1321 of the variable voltage clamping circuits 13 and 15. The clamping to the detection voltages including the high and low voltages HV and LV are then conducted.

As shown in FIG. 2, in addition to the optional differential amplifier 131, the variable voltage clamping circuit 13 or 15 further includes an operational amplifier 1321, resistors 1323 and 1324, and a transistor 1322. The operational amplifier 1321 has a positive input terminal, a negative input terminal, and an output terminal. The negative input terminal receives the high or low analog clamping voltages H or L, respectively. The resistor 1324 has an end coupled to the output terminal of the operational amplifier 1321. The transistor 1322 has its base coupled to another end of the resistor 1324, its emitter connected to ground, and its collector coupled to an end of the resistor 1323. Another end of the resistor 1323 is coupled to the positive input terminal of the operational amplifier 1321.

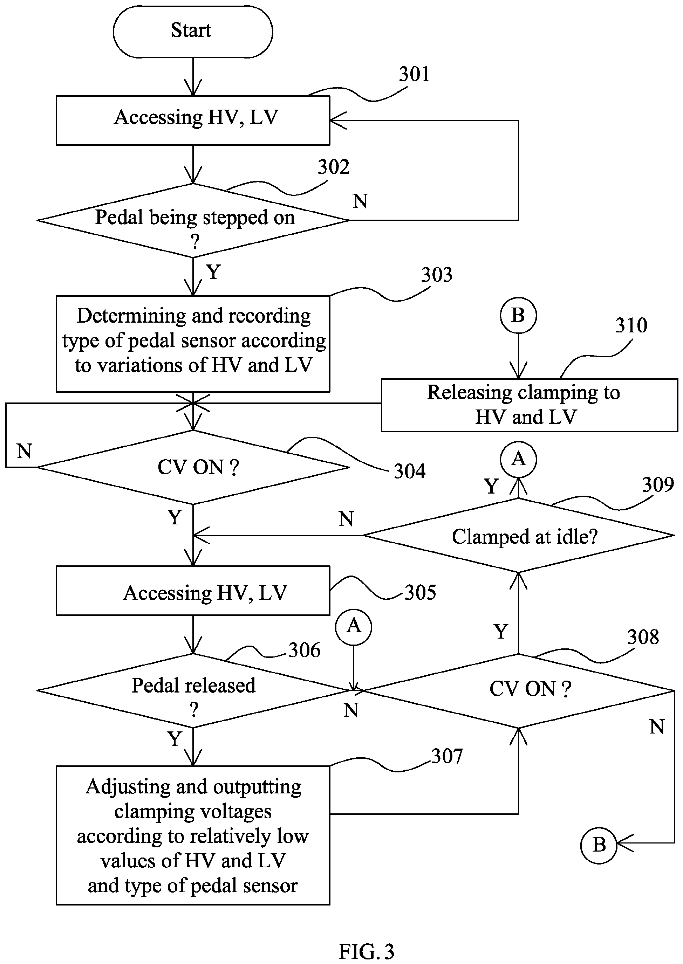

FIG. 3 is a flow diagram showing a vehicle throttle locking method according to an embodiment of the present invention. Firstly, in step 301, a control unit 11 accesses detection voltages including a high voltage HV and a low voltage LV from an accelerator pedal sensor 1. The process then enters step 302, and a status of the pedal is determined. If the vehicle is idle and the pedal is not stepped on, the process returns to step 301. Otherwise, the process enters step 303 and a type of the pedal sensor 1 is determined and recorded according to variations of the high and low voltage HV and LV. The initialization of the process is completed at this stage.

In general, the pedal sensor 1 may be of one of the following types. Firstly, the pedal sensor 1 may be of a parallel type where the high and low voltages HV and LV of the detection voltages have an identical initial value for idle and identical increments. For example, the high and low voltages HV and LV both vary within the same range between 0.3V and 4V. Secondly, the pedal sensor may be of a fixed parallel type where the high and low voltages HV and LV of the detection voltages have different initial values for idle but identical increments. For example, the high voltage HV varies within a range between 1.6V and 4V whereas the low voltage LV varies within a range between 0.8V and 3.2V. Thirdly, the pedal sensor may be of a multiple type where the high and low voltages HV and LV of the detection voltages have different initial values and different increments but one is a multiple of the other. For example, the high voltage HV varies within a range between 0.7V and 4V whereas the low voltage LV varies within a range between 0.35V and 2V.

Therefore, step 303 is able to determine and record the type of the pedal sensor 1 according to variations of the high and low voltage HV and LV for subsequent steps.

In step 304, whether a clamping actuation signal CV is initiated is determined. If the clamping actuation signal CV is not initiated, the process returns to step 304. Otherwise, the process enters step 305 where the high and low voltages HV and LV of the detection voltages output from the pedal sensor 1 is accessed. Then, in step 306, whether the pedal is released to reduce speed is determined. If the pedal is not released to reduce speed, the process enters step 308. Otherwise, if the pedal is released to reduce speed, the process enters step 307 where digital clamping voltages are adjusted according to relatively low (or high) values of the high and low voltages HV and LV and the type of the pedal sensor 1 recorded in step 303, and output the digital clamping voltages.

For example, if the pedal sensor 1 is of the parallel type, and the high and low voltages HV and LV are both 3.6V before the pedal is released, and the high voltage HV becomes 3.0V and the low voltage LV becomes 2.9V after the pedal is released, step 307 adjusts and output digital clamping voltages so that the high and low voltages HV and LV are both clamped at the relatively low value 2.9V.

If the pedal sensor 1 is of the fixed parallel type, and the high and low voltages HV and LV are 3.6V and 2.8V, respectively, before the pedal is released, and the high voltage HV becomes 3.0V and the low voltage LV becomes 2.1V after the pedal is released, step 307 adjusts and output digital clamping voltages so that the high and low voltages HV and LV are clamped at the relatively low values 2.9V and 2.1V, respectively.

If the pedal sensor 1 is of the multiple type, and the high and low voltages HV and LV are 3.6V and 1.8V, respectively, before the pedal is released, and the high voltage HV becomes 3.0V and the low voltage LV becomes 1.4V after the pedal is released, step 307 adjusts and output digital clamping voltages so that the high and low voltages HV and LV are clamped at the relatively low values 2.8V and 1.4V, respectively.

In step 308, whether the clamping actuation signal CV is still ON is determined. If it is not ON, the process enters step 310 and clamping to the high and low voltages HV and LV are released so that the vehicle is restored a normal driving condition. Otherwise, the process enters step 309 and whether the detection voltages are already clamped at an idle condition is determined. If yes, the process returns to the step 308 so as to wait for the clamping actuation signal CV to be OFF and to release the clamping to the high and low voltages HV and LV. Otherwise, the process enters step 305 and repeats a next cycle of operation.

While certain novel features of this invention have been shown and described and are pointed out in the annexed claim, it is not intended to be limited to the details above, since it will be understood that various omissions, modifications, substitutions and changes in the forms and details of the device illustrated and in its operation can be made by those skilled in the art without departing in any way from the claims of the present invention.

## Claims

1. A throttle locking circuit for a vehicle equipped with an accelerator pedal sensor (1) and an Electronic Control Unit (ECU) (2) where the pedal sensor (1) outputs at least one detection voltage corresponding to a depth of the pedal being stepped on to the ECU (2), comprising
a control unit (11) coupled to the pedal sensor (1) for receiving a clamping actuation signal (CV) and, when the clamping actuation signal (CV) is ON, outputting at least one digital clamping voltage according to the at least one detection voltage;
a digital-analog (D/A) conversion unit (21) coupled to the control unit (11) for converting the at least one digital clamping voltage into at least one analog clamping voltage; and
a variable voltage clamping unit (31) coupled to the D/A conversion unit (21) for clamping the at least one detection voltage according to the at least one analog clamping voltage.

2. The throttle locking circuit according to claim 1, wherein the at least one detection voltage comprises a high voltage (HV) and a low voltage (LV); the at least one digital clamping voltage comprises a high digital value (h) and a low digital value (1); and the control unit (11) outputs the digital clamping voltages of the high digital value (h) and the low digital value (1) in accordance with the high and low voltages (HV, LV) of the detection voltages.

3. The throttle locking circuit according to claim 2, wherein the D/A conversion unit comprises two D/A converters (12,14) converting the digital clamping voltages of the high digital value (h) and the low digital value (1) into analog clamping voltages comprising a high analog clamping voltage (H) and a low analog clamping voltage (L), respectively.

4. The throttle locking circuit according to claim 3, wherein the variable voltage clamping unit (31) comprises two variable voltage clamping circuits (13, 15) clamping the high and low voltages (HV, LV) of the detection voltages according to the high and low analog clamping voltages (H, L), respectively.

5. The throttle locking circuit according to claim 4, wherein each variable voltage clamping circuit (13 or 15) comprises
an operational amplifier (1321) having a positive input terminal, a negative input terminal, and an output terminal where the negative input terminal directly or indirectly receives the high or low analog clamping voltage (H or L);
a first resistor (1324) having an end coupled to the output terminal;
a transistor (1322) having its base coupled to another end of the first resistor (1324) and its emitter connected to ground; and
a second resistor (1323) having its two ends coupled to the collector of the transistor (1322) and the positive input terminal, respectively.

6. The throttle locking circuit according to claim 5, wherein the high and low analog clamping voltages (H, L) are differential voltages, respectively; and each variable voltage clamping circuit (13 or 15) further comprises a differential amplifier (131) between one of the D/A converter (12 or 14) and the negative input terminal of the operational amplifier (1321) for amplifying one of the differential voltages (H or L).

7. The throttle locking circuit according to claim 6, wherein each differential amplifier (131) comprises
a second operational amplifier (1311) having a positive input terminal, a negative input terminal, and an output terminal where the positive and negative input terminals receive the differential voltages (H, L), respectively;
a third resistor (1315) having an end coupled to the output terminal of the second operational amplifier (1311);
a second transistor (1312) having its base coupled to another end of the third resistor (1315) and its emitter connected to ground;
a fourth resistor (1313) having its two ends coupled to the collector of the second transistor (1312) and the positive input terminal of the second operational amplifier (1311), respectively; and
a fifth resistor (1314) having its two ends coupled to the collector of the second transistor (1312) and a power source, respectively.

8. A throttle locking method for a vehicle equipped with an accelerator pedal sensor (1) and a ECU (2) where the pedal sensor (1) outputs at least one detection voltage corresponding to a depth of the pedal being stepped on to the ECU (2), comprising
providing at least one digital clamping voltage according to the at least one detection voltage when a clamping actuation signal (CV) is ON;
converting the at least one digital clamping voltage to at least one analog clamping voltage; and
clamping the at least one detection voltages according to the at least one analog clamping voltage.

9. The throttle locking method according to claim 8, wherein the at least one detection voltage comprises a high voltage (HV) and a low voltage (LV); and the method further comprises
determining and recording a type of the pedal sensor (1) according to the high and low voltages (HV, LV) of the detection voltages.

10. The throttle locking method according to claim 9, further comprising
adjusting and providing the at least one digital clamping voltage when the detection voltages suggest that the pedal is released to reduce speed.

11. The throttle locking method according to claim 10, wherein the at least one digital clamping voltage is adjusted according to relatively low values of the high and low voltages (HV, LV) of the detection voltages and the type of the pedal sensor (1).

12. The throttle locking method according to claim 8, further comprising
stopping reducing to the at least one digital clamping voltage when the at least one detection voltage is already clamped at an idle condition.

## Patentansprüche

1. Schaltung zum Blockieren einer Drosselklappe für ein Fahrzeug, das mit einem Gaspedalsensor (1) und einer elektronischen Steuereinheit (ECU) (2) ausgestattet ist, wobei der Pedalsensor (1) mindestens eine Erkennungsspannung an die ECU (2) ausgibt, je nachdem, wie tief das Pedal gedrückt wurde, mit einer Steuereinheit (11), die mit dem Pedalsensor (1) zwecks Empfang eines Klemmbetätigungssignals (CV) verbunden ist, und, wenn das Klemmbetätigungssignal (CV) ON ist, Ausgabe mindestens einer digitalen Klemmspannung entsprechend der mindestens einen Erkennungsspannung; einer digital-analogen AD/DA-Wandlungseinheit (21), die mit der Steuereinheit (11) verbunden ist, zur Umwandlung der mindestens einen digitalen Klemmspannung in mindestens eine analoge Klemmspannung; und
einer spannungsvariablen Begrenzungseinheit (31), die mit der AD/DA-Wandlungseinheit (21) verbunden ist, zum Begrenzen der mindestens einen Erkennungsspannung entsprechend der mindestens einen analogen Klemmspannung.

2. Schaltung zum Blockieren einer Drosselklappe nach Anspruch 1, wobei die mindestens eine Erkennungsspannung eine Hochspannung (HV) und eine Niederspannung (LV) umfasst; die mindestens eine digitale Klemmspannung umfasst einen hohen digitalen Wert (h) und einen niedrigen digitalen Wert (1);
und die Steuereinheit (11) gibt die digitalen Begrenzungsspannungen des hohen digitalen Wertes (h) und des niedrigen digitalen Wertes (I) aus, in Übereinstimmung mit der hohen und niedrigen Spannung (HV, LV) der Erkennungsspannungen.

3. Schaltung zum Blockieren einer Drosselklappe nach Anspruch 2, wobei die AD/DA-Wandlungseinheit zwei DA-Wandler (12, 14) zur Umwandlung der digitalen Begrenzungsspannungen des hohen digitalen Wertes (h) und des niedrigen digitalen Wertes (1) in analoge Begrenzungsspannungen umfasst, mit einer hohen analogen Begrenzungsspannung (H) bzw. einer niedrigen analogen Begrenzungsspannung (L).

4. Schaltung zum Blockieren einer Drosselklappe nach Anspruch 3, wobei die spannungsvariable Klemmeinheit (31) zwei veränderliche Spannungsbegrenzungsschaltungen (13, 15) umfasst, die die Hoch- und Niederspannungen (HV, LV) der Erkennungsspannungen begrenzen, entsprechend den hohen bzw. niedrigen analogen Begrenzungsspannungen (H, L).

5. Schaltung zum Blockieren einer Drosselklappe nach Anspruch 4, wobei jede spannungsvariable Begrenzungsschaltung (13 oder 15) einen Operationsverstärker (1321) umfasst, der eine positive Eingangsklemme, eine negative Eingangsklemme und eine Ausgangsklemme umfasst, wobei die negative Eingangsklemme direkt oder indirekt die hohe oder niedrige analoge Begrenzungsspannung (H oder L) aufnimmt;
einen ersten Widerstand (1324), dessen eines Ende mit der Ausgangsklemme verbunden ist; einen Transistor (1322), dessen Basis mit einem anderen Ende des ersten Widerstandes (1324) verbunden ist und dessen Emitter mit dem Boden verbunden ist; und einen zweiten Widerstand (1323), dessen beide Enden mit dem Kollektor des Transistors (1322) bzw. der positiven Eingangsklemme verbunden sind.

6. Schaltung zum Blockieren einer Drosselklappe nach Anspruch 5, wobei die hohen und niedrigen analogen Begrenzungsspannungen (H, L) jeweils Differentialspannungen sind; und jede spannungsvariable Begrenzungsschaltung (13 oder 15) umfasst des Weiteren einen Differenzverstärker (131) zwischen einem der DA-Wandler (12 oder 14) und der negativen Eingangsklemme des Operationsverstärkers (1321) zur Verstärkung einer der Differentialspannungen (H oder L).

7. Schaltung zum Blockieren einer Drosselklappe nach Anspruch 6, wobei jeder Differenzverstärker (131) folgendes umfasst:
einen zweiten Operationsverstärker (1311) mit einer positiven Eingangsklemme, einer negativen Eingangsklemme und einer Ausgangsklemme, wobei die positive und die negative Eingangsklemme die Differentialspannungen (H bzw. L) aufnehmen;
einen dritten Widerstand (1315), dessen eines Ende mit der Ausgangsklemme des zweiten Operationsverstärkers (1311) verbunden ist;
einen zweiten Transistor (1312), dessen Basis mit einem anderen Ende des dritten Widerstandes (1315) verbunden ist und dessen Emitter mit dem Boden verbunden ist;
einen vierten Widerstand (1313), dessen beide Enden mit dem Kollektor des zweiten Transistors (1312) bzw. der positiven Eingangsklemme des zweiten Operationsverstärkers (1311) verbunden sind; und
einen fünften Widerstand (1314), dessen beide Enden mit dem Kollektor des zweiten Transistors (1312) bzw. einer Energiequelle verbunden sind.

8. Verfahren zum Blockieren einer Drosselklappe für ein Fahrzeug, das mit einem Gaspedalpedalsensor (1) und einer ECU (2) ausgestattet ist, wobei der Pedalsensor (1) mindestens eine Erkennungsspannung an die ECU (2) ausgibt, die einer Tiefe des Pedals entspricht, auf das man tritt, mit
Bereitstellung mindestens einer digitalen Begrenzungsspannung, entsprechend der mindestens einen Erkennungsspannung, wenn ein Klemmbetätigungssignal (CV) ON ist; Umwandlung der mindestens einen digitalen Begrenzungsspannung in mindestens eine analoge Begrenzungsspannung; und
Begrenzen der mindestens einen Erkennungsspannung entsprechend der mindestens einen analogen Begrenzungsspannung.

9. Verfahren zum Blockieren einer Drosselklappe nach Anspruch 8, wobei die mindestens eine Erkennungsspannung eine Hochspannung (HV) und eine Niederspannung (LV) umfasst; und das Verfahren umfasst des weiteren die Bestimmung und Aufzeichnung eines Pedalsensor-Typs (1) entsprechend der Hochspannungen und Niederspannungen (HV, LV) der Erkennungsspannungen.

10. Verfahren zum Blockieren einer Drosselklappe nach Anspruch 9, mit Einstellung und Bereitstellung der mindestens einen digitalen Begrenzungsspannung, wenn die Erkennungsspannungen andeuten, dass das Pedal losgelassen wird, um die Geschwindigkeit zu reduzieren.

11. Verfahren zum Blockieren einer Drosselklappe nach Anspruch 10, wobei die mindestens eine digitale Begrenzungsspannung gemäß verhältnismäßig niedrigen Werten der Hochspannung und Niederspannung (HV, LV) der Erkennungsspannungen und dem Typ des Pedalsensors (1) eingestellt wird.

12. Verfahren zum Blockieren einer Drosselklappe nach Anspruch 8 mit dem Stoppen der Reduzierung auf die mindestens eine digitale Begrenzungsspannung, wenn die mindestens eine Erkennungsspannung schon im Leerlauf begrenzt wird.

## Revendications

1. Circuit de blocage d'accélérateur pour un véhicule équipé d'un capteur de pédale d'accélérateur (1) et d'une unité de commande électronique (UCE) (2), où le capteur de pédale (1) émet au moins une tension de détection qui correspond à une profondeur du pédale sur lequel on appuie à l'UCE (2), comprenant une unité de commande (11) accouplée au capteur de pédale (1) pour recevoir un signal d'actionnement de blocage (CV) et, lorsque le signal d'actionnement de blocage (CV) est activé, émettre au moins une tension de blocage numérique selon l'au moins une tension de détection;
une unité de conversion numérique-analogique (N/A) (21) accouplé à l'unité de commande (11) pour convertir l'au moins une tension de blocage numérique en au moins une tension de blocage analogique; et
une unité de blocage à tension variable (31) accouplée à l'unité de conversion N/A (21) pour bloquer l'au moins une tension de détection selon l'au moins une tension de blocage analogique.

2. Circuit de blocage d'accélérateur selon la revendication 1, où l'au moins une tension de détection comprend une haute tension (HV) et une basse tension (LV); l'au moins une tension de blocage numérique comprend une valeur numérique haute (h) et une valeur numérique basse (1); et l'unité de commande (11) émet les tensions de blocage numériques de la valeur numérique haute (h) et de la valeur numérique basse (I) selon les tensions haute et basse (HV, LV) des tensions de détection.

3. Circuit de blocage d'accélérateur selon la revendication 2, où l'unité de conversion N/A comprend deux convertisseurs N/A (12, 14) convertissant les tensions de blocage numériques de la valeur numérique haute (h) et la valeur numérique basse (1) en des tensions de blocage analogiques comprenant une haute tension de blocage analogique (H) et une basse tension de blocage analogique (L), respectivement.

4. Circuit de blocage d'accélérateur selon la revendication 3, où l'unité de blocage à tension variable (31) comprend deux circuits de blocage à tension variable (13, 15) bloquant les tensions haute et basse (HV, LV) des tensions de détection selon les tensions de blocage analogique haute et basse (H, L), respectivement.

5. Circuit de blocage d'accélérateur selon la revendication 4, où chaque circuit de blocage à tension variable (13 ou 15) comprend un amplificateur opérationnel (1321) ayant une borne d'entrée positive, une borne d'entrée négative, et une borne de sortie, où la borne d'entrée négative reçoit directement ou indirectement la tension de blocage analogique haute ou basse (H ou L); une première résistance (1324) ayant une extrémité accouplée à la borne de sortie; un transistor (1322) ayant sa base accouplée à une autre extrémité de la première résistance (1324) et son émetteur connecté à terre; et une deuxième résistance (1323) ayant ses deux extrémités accouplées au collecteur du transistor (1322) et à la borne d'entrée positive, respectivement.

6. Circuit de blocage d'accélérateur selon la revendication 5, où les tensions de blocage analogiques haute et basse (H, L) sont des tensions différentiels, respectivement; et chaque circuit de blocage à tension variable (13 ou 15) comprend ultérieurement un amplificateur différentiel (131) entre un du convertisseur N/A (12 ou 14) et la borne d'entrée négative de l'amplificateur opérationnel (1321) pour amplifier une des tensions différentielles (H ou L).

7. Circuit de blocage d'accélérateur selon la revendication 6, où chaque amplificateur différentiel (131) comprend
un deuxième amplificateur opérationnel (1311) ayant une borne d'entrée positive, une borne d'entrée négative, et une borne de sortie, où les bornes d'entrée négative et positive reçoivent les tensions différentiels (H, L), respectivement;
une troisième résistance (1315) ayant une extrémité accouplé à la borne de sortie du deuxième amplificateur opérationnel (1311);
un deuxième transistor (1312) ayant sa base accouplé à une autre extrémité de la troisième résistance (1315) et son émetteur connecté à terre;
une quatrième résistance (1313) ayant ses deux extrémités accouplées au collecteur du deuxième transistor (1312) et à la borne d'entrée positive du deuxième amplificateur opérationnel (1311), respectivement; et
une cinquième résistance (1314) ayant ses deux extrémités accouplées au collecteur du deuxième transistor (1312) et à une source d'alimentation, respectivement.

8. Procédé de blocage d'accélérateur pour un véhicule équipé avec un capteur de pédale d'accélérateur (1) et une UCE (2), où le capteur de pédale (1) émet au moins une tension de détection qui correspond à une profondeur du pédale sur lequel on appuie à l'UCE (2), comprenant
fournir au moins une tension de blocage numérique selon l'au moins une tension de détection quand un signal d'actionnement de blocage (CV) est activé;
convertir l'au moins une tension de blocage numérique en au moins une tension de blocage analogique; et
bloquer au moins une tension de détection selon l'au moins une tension de blocage analogique.

9. Procédé de blocage d'accélérateur selon la revendication 8, où l'au moins une tension de détection comprend une haute tension (HV) et une basse tension (LV); et le procédé comprend en plus
déterminer et enregistrer un type de capteur de pédale (1) selon les tensions haute et basse (HV, LV) des tensions de détection.

10. Procédé de blocage d'accélérateur selon la revendication 9, comprenant en outre ajuster et fournir l'au moins une tension de blocage numérique quand les tensions de détection suggèrent que le pédale est libéré pour réduire la vitesse.

11. Procédé de blocage d'accélérateur selon la revendication 10, où l'au moins une tension de blocage numérique est ajustée selon des valeurs relativement basses des tensions haute et basse (HV, LV) des tensions de détection et le type du capteur de pédale (1).

12. Procédé de blocage d'accélérateur selon la revendication 8, comprenant en outre arrêter la réduction à l'au moins une tension de blocage numérique quand l'au moins une tension de détection est déjà bloqué dans un état inactif.
